# EUROPEAN PATENT APPLICATION

(11) **EP 4 560 327 A1**
(43) Date of publication of application: **28.05.2025**
(21) Application number: 23212171.5
(22) Date of filing: 27.11.2023
(51) Int. Cl.: G01R 29/08

(54) **A METHOD AND A SYSTEM FOR THREE-DIMENSIONAL MEASURING OF LIGHTNING STROKES**

(71) Applicant: UBIMET GmbH, 1220 Wien (AT)
(72) Inventor: The designation of the inventor has not yet been filed
(74) Representative: DTS Patent- und Rechtsanwälte PartmbB

(57) **Abstract**

The present invention relates to a method (10) for three-dimensional measuring of lightning strokes (L) comprising the steps of:
- recording, at a plurality of remote stations (110, 120), electromagnetic waves generated by a lightning stroke (L);
- pre-processing the recorded electromagnetic wave data;
- transferring the pre-processed electromagnetic wave data of the plurality of remote stations (110, 120) to at least one data processing device (140) via at least one data network (130);
- processing the transferred electromagnetic wave data of the plurality of remote stations (110, 120) at the at least one data processing device (140); and
- determining a resolution of the lightning stroke (L) based on the processed electromagnetic wave data.

## Description

The present invention relates to a method for three-dimensional measuring of lightning strokes. Furthermore, the present invention relates to a system for three-dimensional measuring of lightning strokes.

In practice, it is known that a lightning stroke generates electromagnetic pulses (or radio-frequency emissions) which are transmitted as electromagnetic waves in the V[ery]L[ow]F[requency] band, i.e. in a band of 1 kHz to 30 kHz. These electromagnetic waves can be detected and recorded by lightning detection systems having a plurality of detecting stations; such systems have been in use worldwide for about more than fifteen years now and allow the localization of ground lightnings with increasing local accuracy. The accuracy of modern systems is in the range of less than one kilometer. The detection efficiency for lightnings with an intensity of current of more than 5 kA is usually over ninety percent, but no statistically reliable data are known for weakerlightnings. A GPS based clock serves as precise time reference at the sensor, wherein its precision may be up to 100 nanoseconds.

Usually, the plurality of detecting stations send information and precise timings of the incident electromagnetic signal to a central processing unit. At the central processing unit, the matching signals of the different detecting stations are combined and an optimization algorithm is applied to determine the most probable location and time of the corresponding lightning stroke using for example the so-called "time of arrival (TOA)"-method.

Traditionally, operational detection systems or networks are designed in such a way that mainly (cloud-to-)ground lightning (= C[loud-]G[round]) is reported and cloud-to-cloud lightning (= I[ntra]C[loud] within a thundercloud or C[loud-]C[loud] between thunderclouds) is suppressed as far as possible. Recently, however, there has been a growing trend to also record discharges in the clouds for meteorological purposes.

However, the lightning tracking or detecting methods used over large areas worldwide are based on less intricate 2D systems, where a distinction between CG lightnings and IC/CC lightnings is difficult. Although some manufacturers report on reliable distinction methods based on the shape of the electromagnetic wave, the literature on this issue is highly contradictory.

A distinction between CG lightnings and IC/CC lightnings is possible with special methods, in particular with 3D methods, wherein measurements in the VLF range and in the V[ery]H[igh]F[requency] range can also be combined (cf. inter alia Kawasaki, Z.-I. et al. (1994), "SAFIR operation and evaluation of its performance", Geophys. Res. Lett. 21 (12), pages 1133 to 1166; and Thery, C. (2001), "Evaluation of LPATS data using VHF interferometric observations of lightning flashes during the EULINOX experiment", Atmospheric research 56, pages 397 to 409).

In the paper by Jacobson et al. (2000), "FORTE radio-frequency observations of lightning strokes detected by the National Lightning Detection Network", J. Geophys. Res. 105, pages 15653 to 15662, for example, a 3D method is described in which a 3D direction finding is first taken with VHF radio frequencies and then the associated VLF signal is searched for from an existing two-dimensional (2D) VLF network (so-called NLDN) via temporal coincidence.

Furthermore, Smith et al. (1999) describe in the paper "A distinct class of isolated intracloud lightning discharges and their associated radio emissions", J. Geophys. Res. 104, pages 4189 to 4212, a 3D method, which, however, provides a pure VHF direction finding without any VLF reference.

A 3D method with good resolution of discharge channels is described by Krehbiel et al. (1999) in the paper "Three-dimensional lightning mapping observations during MEAPRS in central Oklahoma", 11th Int. Conf. on Atmosph. Electricity, NASNCP, Alabama, June 1999, pages 376 to 379. However, this method again has no VLF reference and is based purely on VHF direction finding in the clouds.

Moreover, Cummins, K. L. et al. (2000) describe in the paper "Lightning detection methods and meteorological applications", IV. International Symposium on Military Meteorology, Malbork, September 26 to 28, 2000, a proposal to use three detection technologies and localization methods (VLF, LF and VHF) for different lightning discharges using networks consisting of radiation detecting (especially electromagnetic radiation from a lightning discharge) sensors.

Very early on, in the paper by Taylor (1978), "A VHF technique for space-time mapping of lightning discharge processes", J. Geophys. Res. 83, pages 3575 to 3583, the possibility of direct spatial direction finding of high emission sites by means of time measurements was shown. This known method uses two closely neighboring stations, each of which also requires two sensors in a vertical arrangement (one close to the ground and the other at a height of about fifteen meters) to measure time differences in the range of nanoseconds and thereby determine the elevation angles, the intersection of which gives the emission locations by means of triangulation.

DE 10 2004 000 025 B4 further describes the use of a measuring station with an antenna body formed for measuring low-frequency magnetic fields for a lightning detection network with several spatially separated measuring stations as a pseudo three-dimensional (3D) network for identifying discharges emitted in thunderclouds from a great height.

In the publication DE 41 33 209 A1, a method for detecting data of electromagnetic waves in the atmosphere is disclosed, which are of natural origin and thereby result in meteorological processes, which can, measurably detectable, propagate up to several thousand kilometers and are preferably to be assigned to the frequency range of 1 kHz to 100 kHz.

From the publication WO 98/58279 A1, an electromagnetic measuring system for meteorology is further known, which contains a plurality of measuring stations spatially distributed in a predetermined spatial area.

Further 3D methods are described in the following documents:
- Richard and Auffray (1985), "VHF-UHF interferometric measurements, applications to lightning discharge mapping", Radio Science 20, pages 171 to 192;
- Rhodes et al. (1994), "Observations of lightning phenomena using radio interferometry", J. Geophys. Res. 99, pages 13059 to 13082;
- Laroche et al. (1996), "3D structure of lightning discharge within storms", 10th Int. Conf. Atmosph. Electricity, Osaka, June 10 to 14, 1996, pages 330 to 332;
- Onuki et al. (1996), "Imaging of lightning channel in three dimensions using interferometer", 10th Int. Conf. Atmosph. Electricity, Osaka, June 10 to 14, 1996, pages 325 to 332; and
- Richard and Lojou (1996), "Assessment of application of storm cell electrical activity monitoring to intense precipitation forecast", 10th Int. Conf. Atmosph. Electricity, Osaka, June 10 to 14, 1996, pages 284 to 287.

In order to optimize the localization of a lightning stroke, among others, the time of arrival at the sensors, the waveform characteristics as well as the polarity of the detected electromagnetic waves emitted by a lightning stroke have been identified as promising values or parameters for an analysis and evaluation.

In this regard, Cummins, K. L. et al. describe in the paper "A combined TOA/MDF technology upgrade of the U.S. national lightning detection network", Journal of Geophysical research: Atmospheres, Vol. 103, 1998, No. D8, pages 9035 to 9044, a lightning detection system with a network consisting of over 100 radiation detecting (specifically electromagnetic radiation from a lightning discharge) sensors. In this paper, in particular the design and implementation of a signal propagation time-based or directional finding-based sensor network is discussed as well as the detected data, both regarding potential for improvement.

Moreover, US 5 771 020 A discloses a lightning detection system for detecting and locating an initial discharge of an initial stroke of a lightning. An initial discharge of lightning generates a pulse that can be used to accurately detect the lightning, and in particular the location of the initial lightning discharge. For this purpose, according to an embodiment of US 5 771 020 A, at least three sensors detect and determine the location of the first pulses starting from initial lightning discharges by using the time difference of the information arrival of the pulses at each of the three sensors.

US 8,073,622 B2 further discloses a long-range lightning detection and characterization system and method, according to which an electromagnetic radiation produced by a lightning strike is sensed at a sensing location and a measured signal representative of the strike is produced that defines an amplitude versus time. A set of reference data containing waveforms comparable to the measured signal is established. The set of reference data defines a set of reference amplitudes versus time, representative of one or more predetermined reference lightning strikes at various predetermined distances, where for each of the distances, the reference lightning strikes have associated therewith various predetermined day/night percentages. The measured signal is compared with the reference data, the comparison including finding a correlation between the measured signal and a correlating waveform in the reference data. At least one of a propagation distance, a time-of-arrival, a polarity, and an amplitude of the measured signal is inferred by reference to the correlating waveform.

EP 1 711 843 B1 further describes a system for recording, transmitting, and evaluating data and information generated by electromagnetic radiation, in particular low-frequency radiation, which has a plurality of spatially separated measuring stations, each of which is provided with at least one broadband antenna body for recording electromagnetic radiation and at least one time-measuring device and a GPS system.

US 2020/0292653 A1 presents methods and systems which determine an average arrival time of a radio wave emitted by a lightning discharge and/or determine the lobe and/or polarity of the radio wave. The determination of the average arrival time may take a weighted average of arrival times of peaks of the radio wave. The determination of the lobe and/or polarity may depend on an estimated propagation distance, a propagation path profile, and one or more waveform features.

In addition, with regard to suitable antennas, Parmigiani, R. et al. disclose a VLF antenna, called "bikeloop" (URL: http://www.vlf.it/bikeloop/bykeloop.htm), whose body is formed by two coils orthogonally aligned to each other and adapted to receive VLF waves originating from natural and/or non-natural origin, while in Limann, O. (1978), "Funktechnik ohne Ballast", 14th edition, Franzis-Verlag GmbH, Munich; pages 210 to 212, examples of a capacitive and an inductive antenna coupling for amplitude modulation (AM) antennas as well as the use of external and ferrite antennas in the medium wave (MW) and long wave (LW) range are disclosed.

Therefore, it is an object of the present invention to advantageously further develop a method and a system of the aforementioned kind, in particular in such a way that the determination of the lightning stroke location is further optimized.

The aforesaid object with respect to a method for three-dimensional measuring of lightning strokes is achieved by the features of claim 1.

A method for three-dimensional measuring of lightning strokes is provided, which comprises the steps of:
- recording, at a plurality of remote stations, electromagnetic waves generated by a lightning stroke;
- pre-processing the recorded electromagnetic wave data;
- transferring the pre-processed electromagnetic wave data of the plurality of remote stations to at least one data processing device via at least one data network;
- processing the transferred electromagnetic wave data of the plurality of remote stations at the at least one data processing device; and
- determining a resolution of the lightning resolution based on the processed electromagnetic wave data.

The invention is based on the basic idea that an electromagnetic wave, electromagnetic radiation or signal emitted or generated by a lightning stroke, which is detected and received at a plurality of remote stations, is first pre-processed, preferably at the respective receiving remote stations, by means of at least one machine learning method, and then the corresponding pre-processed data is transmitted from the remote stations to and further processed at a data processing device or central processing unit where substantially an optimization algorithm is applied to the received data set, based on the arrival time of the signals, to determine inter alia the most probable location and time of the lightning stroke originally emitting the electromagnetic waves. The use of a machine learning method to pre-process the received signal has the advantage that, highly efficiently, the relevant signal components are already determined in the area of the remote stations, which then enables the location and time of the lightning stroke to be determined as accurately as possible in the further course, i.e. at the data processing device. Thus, a complex processing step is established upstream and distributed, which inter alia speeds up the determination of the location and time of the lightning stroke at the data processing device. Referring to the pre-processing, preferably a big data method like a neural network is applied which has been trained with reference signals of lightning strokes with a known location and time. These networks form probability-weighted associations between the input parameters (dataset of the received electromagnetic wave) and the results (location and time of the lightning stroke), wherein the training of a neural network from a known example is usually conducted by determining the difference between the processed output of the network (often a prediction) and a target output and sufficiently adjusting the weighted associations using the difference as an error value. Consequently, the neural network determines essential signal characteristics or features, which are then used to derive the corresponding lightning stroke at data processing device.

In the following, the terms electromagnetic waves, electromagnetic radiation and signal (measurable physical quantity) are used synonymously, unless otherwise indicated.

The electromagnetic wave emitted by a lightning stroke falls into the class of VLF signals. These signals propagate in two different modes, either as a ground wave or as a sky wave. The travel path of ground waves is parallel to the earth's surface. Its travel time between an emitter and a receiver is therefore only dependent on the distance between emitter and receiver. Sky waves, on the other hand, are reflected by an atmospheric layer, called ionosphere, and travel by means of reflections, called "hops", between the earth's surface and the ionosphere. Depending on the number n of "hops", the sky waves are denoted as first sky wave, second sky wave, etc. for n = 1, 2, .... The travel path of a sky wave depends on its order n and the height of the ionosphere, wherein the ionospheric reflection height changes with the day time (this can also be implemented and introduced into the calculation). The importance of the different modes of signal or wave propagation for the signal strength varies with increasing distance. Hence, the ground wave propagation is most important for distances up to 1000 km, then the sky wave propagation becomes more significant. Consequently, part of the processing of the data received at the remote detecting stations concerns the differentiation of the two propagation modes in order to be able to resolve the location, extension, and time of a lightning stroke as precisely as possible.

In a possible embodiment of the invention, the resolution of the lightning stroke comprises at least a time and a location of the lightning stroke. The location is preferably composed of latitude, longitude and height of the lightning stroke. Further resolution parameters can be the amplitude and polarity. In order to be able to evaluate the quality of the performed determination of the lightning stroke characteristics, the indication of an uncertainty of the results is conceivable.

After detecting and recording, at a plurality of remote stations, electromagnetic waves generated by a lightning stroke, the signal strength of the waves is compared to a threshold value. If the signal strength exceeds said threshold value, the pre-processing of the signal is invoked or performed, wherein the pre-processing can be conducted directly at the remote stations or at (additional) units which are in data exchange with the remote stations.

In a further possible embodiment of the invention, recording comprises converting the detected electromagnetic waves generated by a lightning stroke into electromagnetic wave data.

To be (pre-)processable by the methods described herein, the detected signals have to be converted from analogue to digital, i.e. the detected and received electromagnetic waves are converted into electromagnetic wave data e.g. by an analogue-to-digital converter (ADC).

In a further possible embodiment of the invention, pre-processing comprises applying at least one machine learning method as described above.

In a further possible embodiment of the invention, pre-processing comprises storing the pre-processed electromagnetic wave data.

The results of the pre-processing can be stored at the remote stations or at separate storages unit linked to the remote stations.

The pre-processed data is transmitted to a data processing device via a data network. The established data network can be wired, wireless or a combination of wired and wireless connections, where required. Separate networks for transmission are also conceivable, as long as the data sets are brought together at a central unit for further processing.

In a further possible embodiment of the invention, pre-processing comprises determining from a waveform of the electromagnetic wave data at least one feature of the group of zero-crossings, halfway points between neighbouring peaks, and first threshold exceeding points.

The pre-processing of the electromagnetic wave data at the remote stations, which is performed by a processor, comprises determining or extracting specific features from the waveform or signal shape as well as specific metadata. Such features can be zero-crossings, halfway points between a peak and the neighboring one, or the time point when the signal intensity first crosses a defined percentage of its maximum intensity. For each of these extracted features, a corresponding amplitude and arrival time is determined.

A key aspect of the determining is to assign a propagation mode to each feature such that the specific propagation path can be taken into account in the subsequent calculations, wherein the propagation mode can also be could named generation, group identity, stage, classification, tier, rank, step, or degree.

As a result, the received signal components resulting, for example, from the different directions of propagation of an electromagnetic wave and/or different propagation paths, i.e. ground wave or sky wave with n hops, can be distinguished. Such distinction is necessary to be able to assign a travelled distance, an incident angle and time to the individual signal components, as a result of which the totality of the individual components permits a high spatial resolution of a lightning stroke.

Practically speaking, each e.g. zero-crossing in a signal has a distinct origin in the physics of lightning propagation. There is a zero-crossing between the ground wave and the first sky wave, another between first sky wave and the second sky wave etc. So, a zero crossing has to be characterized in terms of propagation mode and generation number so that it is derivable whether a specific zero-crossing is one between ground wave and first sky wave (generation number 0), first sky wave and second sky wave (generation 1), and so on.

Referring to the generation number, it is also conceivable that a peak polarity determination can be conducted to match the respective generation number between the different remote stations.

In a further possible embodiment, pre-processing further comprises determining from the waveform metadata of the group of estimated propagation distance, polarity, and incident angle of the electromagnetic wave.

The incident angle should be understood as the compass direction where the signal is coming from.

Consequently, the characterization of the signal components can be further optimized and thus, the resolution of the lightning stroke.

In another possible embodiment, pre-processing further comprises labelling the features according to the propagation mode.

For each extracted feature, in particular for each zero-crossing, the propagation mode, also called generation, is determined. In other words, the different signal components are classified according to their propagation mode. This allows the signal components to be processed in the further analysis according to their propagation mode, wherein signal components of the same generation can be grouped.

If the identification of the generation of the features at the remote stations is not completely certain, the remaining ambiguity can be resolved when the signal data from the multiple remote stations is combined at the data processing device. In this regard, different generation assignments lead to different stroke polarity assessments. Thus, signal data from multiple remote stations can then be combined in such a way that the polarity matches. The matching can either rely upon an assessment that such a polarity might be correct which most of the combined signal components have or the generation assignment is associated with a probability such that the signal components with the highest probability are combined primarily.

The determination of the feature labels is performed by a machine learning method, such as neural networks, support vector machines, tree-based methods, or even linear regression. However, the application of a neural network model is preferred, since neural networks have the advantage that, if properly trained, they are usually less sensitive to noisy data or disturbances in the input patterns than conventional algorithms. The neural network is trained with reference signals from lightning strokes of which the time and location are known.

The resulting data set of feature labels, features and metadata is subsequently transferred to the data processing device via the data network.

In yet another possible embodiment, processing comprises ordering the transferred electromagnetic wave data by the time of arrival.

After gathering the electromagnetic wave data of the remote stations at the at least one data processing device, a temporal ordering of the data ensures that the corresponding signal components are compared and processed so that the lightning stroke can be correctly mapped in terms of space and time.

At the data processing device, the features, the feature labels, and the metadata of the multiple remote stations are combined and further processed.

This combination is followed by a pre-fitting, by which a rough location and time of the total lightning stroke is determined, the pre-fitting being based on the incident angles and/or the estimated distances and/or the arrival times of the features and/or statistically corrected feature arrival times. A statistical-based correction of the feature arrival times or a machine learning algorithm provided for the correction of the feature arrival times is used to determine the so-called canonical signal arrival times. The first rough estimation of the essential characteristics of a lightning stroke is necessary for the following data optimization steps.

In other words, a canonical signal arrival time is determined, wherein preferably a statistical or a machine learning algorithm is applied. A canonical signal arrival time is understood as a timepoint when the whole signal has arrived or has been received. The definition and consideration of a canonical signal arrival time is based on the fact that the signal components or better the features of a lightning stroke arrive or are detected at different times at each remote station. Thus, it is necessary to order all features over time to a canonical time basis. In view of this, an offset is calculated from the difference between feature arrival time and canonical time basis, wherein the calculation is preferably based on statistical methods. Hence, if a new signal arrives at a remote station, the results of the statistical calculation are used to convert each new feature arrival time into a canonical arrival time. Accordingly, for each arriving feature a new timepoint, denoted as a canonical signal arrival time, is obtained.

It is also possible to merge all canonical signal arrival times of one remote station into a sensor signal time by weighted averaging or preferably a more sophisticated method such as a Kalman filter. Thus, for each remote station one single time is obtained the moment when the signal has completely arrived. This timepoint is based on information gathered from multiple input features.

In another possible embodiment, processing comprises grouping the ordered electromagnetic wave data according to a temporal proximity.

Electromagnetic wave data or signals in close temporal proximity to each other are grouped and an approximation for the lightning stroke location is calculated based on the approximate arrival time of the signal, incident angles, and the estimated travelled distance.

In a further possible embodiment, processing comprises calculating an approximation of the resolution.

The approximation forms the basis for the following optimization of the resolution, since all signals which are compatible with the approximation of the resolution are combined and iteratively refined or optimized.

In a further possible embodiment, determining comprises applying an optimization algorithm to the processed electromagnetic wave data.

Preferably, the optimization algorithm is an iterative algorithm, i.e. an algorithm that proceeds step-by-step without any self-calls (recursions).

In a further possible embodiment, the optimization algorithm is a least squares optimization algorithm.

The use of the method of least squares is suitable in the present case, since estimated distances are already available, which were determined with machine learning at the remote stations. Thus, the possibility of overestimating outliers is excluded or at least minimized. The application of an iterative optimization algorithm has the advantage that measurement and transmission errors can be suppressed.

As mentioned before, all signal data which are compatible with an approximation or estimated lightning stroke location and time are combined and refined iteratively using a least squares optimization algorithm. The distance of the remote stations to the estimated lightning stroke location is taken into account to choose the appropriate propagation mode that is used to determine the exact arrival time of the signal. The arrival time is a non-trivial function of the propagation mode and travel path. Certain parts of this equation can be derived from a-priori considerations while others have to be calibrated using existing signals and information of corresponding strokes.

After the optimization iteration has converged, the data processing device returns inter alia a lightning stroke result which contains the following data:
- latitude, longitude and height of the lightning stroke,
- incident time of the lightning stroke,
- amplitude of the lightning stroke,
- polarity of the lightning stroke, and
- estimation of the uncertainty of the resulting location.

The object of the present invention can further be solved by a system for three-dimensional measuring of lightning strokes, which comprises:
- a plurality of remote stations,
- at least one data network, and
- at least one data processing device,
wherein each remote station comprises at least one antenna configured to detect electromagnetic waves, in particular electromagnetic waves of a very low frequency (VLF) band generated by a lightning stroke, at least one processor configured to pre-process the detected electromagnetic waves by at least one machine learning method, and a GPS clock configured to assign an individual time stamp to each detected electromagnetic wave, and wherein the at least one data processing device is configured to determine the location of the lightning stroke by an optimization algorithm.

The pre-processing of the received signal at a remote station by means of machine learning as well as the precise time allocation of the signal input has the advantage that lightning strokes can be determined more reliably and with a significantly higher resolution.

An increasing number of remote stations is almost proportional to the resolution quality of lightning strokes to be detected. It is further advantageous that with a large number of remote stations, the pre-processing of the signals increases the processing speed at the data processing device.

It is further advantageous that the use of machine learning in the pre-processing of the received signals at the remote stations leads to an improvement in the quality of the pre-processed signal data in the course of the machine learning progress.

In another embodiment of the system, the at least one antenna comprises two at least substantially perpendicularly aligned conductive loops configured to receive the magnetic component of the detected electromagnetic wave.

By arranging the antenna loops in this way, they are compactly galvanically isolated; preferably the electromagnetic fields can be decoupled in a broadband and low-noise manner and can thus be measured true to time.

In a further embodiment, the at least one processor is configured to record the magnetic component of the electromagnetic wave over time.

The remote station may further comprise an ADC, a memory unit configured to record the received electromagnetic wave or signal, a communication interface, and a power supply.

Preferably by the interaction of the ADC, the processor and the memory unit, it is possible to record and evaluate the magnetic component of the electromagnetic wave over time, wherein the ADC converts the incoming analogue signal into a digital signal and the processor then processes this and stores it in the memory unit. It is also conceivable that the processor further processes signals/data stored in the memory unit.

When a signal recorded by a remote station is stronger the usual noise, it is assumed that it was originally generated by a lightning stroke. Only in this case, the signal is processed by means of a machine learning method which preferably has been trained using reference signals of lightning strokes with a known location and incident time.

Based on the shape of the electromagnetic wave, the remote stations are configured to estimate, by means of a machine learning method, the travelled distance of the electromagnetic wave, the incident angle of the electromagnetic wave, the incident time, and the amplitude and the polarity of the lightning stroke.

In another embodiment, the data network is established wired and/or wireless.

Establishing a wireless data network has the advantage that no additional cables have to be installed and a possible repositioning of the remote stations is therefore easy to carry out. On the other hand, wired connections have the advantage that they are less prone to interference and the signal/data transmission speed is usually higher. In practice, a mix of wired and wireless connections is likely to occur, with wired connections being established where the effort does not exceed a certain cost threshold and wireless connections being established over longer distances or where, depending on the terrain, it would be inappropriate to establish wired connections.

Further details and advantages of the present invention and its embodiments will now be described in connection with the drawings.

It is shown in:
- **Fig. 1**: an embodiment of a method for three-dimensional measuring of lightning strokes according to the invention;
- **Fig. 2**: an embodiment of a system for three-dimensional measuring of lightning strokes according to the invention in connection with the embodiment of the method according to the invention shown in **Fig. 1****;**
- **Fig. 3**: a detailed view of an embodiment of a remote station used in the system shown in **Fig. 2****;**
- **Fig .4**: a part of the system shown in **Fig. 2** detecting a ground wave of a cloud-to-ground lightning stroke; and
- **Fig. 5**: the part of the system of **Fig. 4** detecting an intracloud lightning stroke.

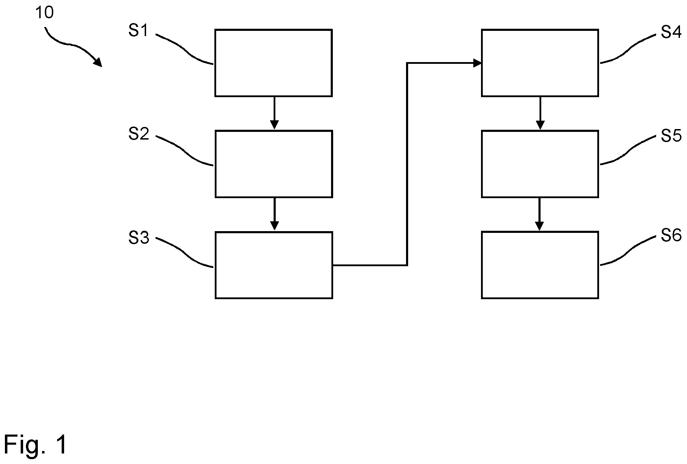

In **Fig. 1****,** an embodiment of the method 10 for three-dimensional measuring of lightning strokes according to the present invention is shown.

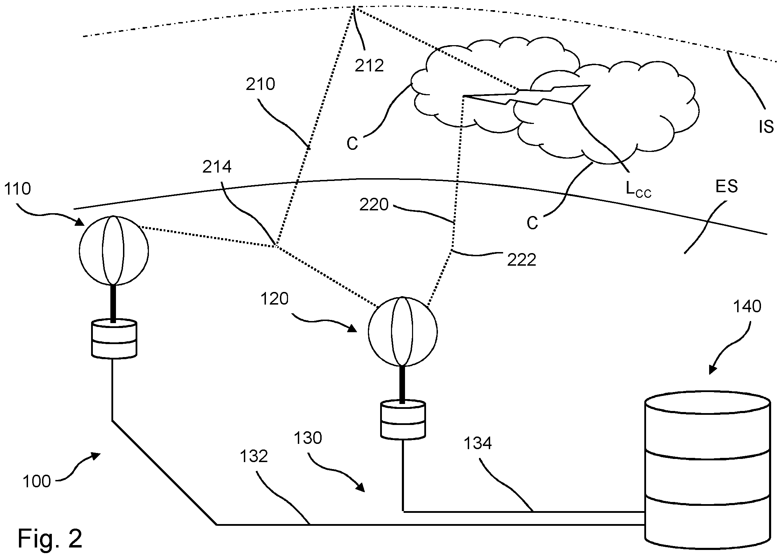

**Fig. 2** shows an embodiment of a system 100 for three-dimensional measuring of lightning strokes according to the invention in connection with the embodiment of the method according to the invention shown in **Fig. 1****.**

It is to be understood that the system 100 of **Fig. 2** is configured to perform or execute the method 10 as presented in **Fig. 1****.**

In **Fig. 1****,** in a first step S1, an electromagnetic wave or signal is detected and recorded at a plurality of remote stations. First step S1 further comprises a conversion from an analogue signal to a digital signal.

In second step S2, the received signal is pre-processed, preferably by a processor of the respective remote station which recorded the signal.

In the pre-processing step S2, specific features and metadata are extracted from the signal shape or waveform.

Moreover, the features are labelled, such that the features are assigned to the different propagation modes and the associated different travel paths. The labelling, which comprises a signal analysis, is performed by means of a machine learning method, in particular by a neural network which is trained with reference lightning stroke values or parameters.

Practically, for example, each zero-crossing of a received signal has a distinct origin in the physics of the lightning propagation, i.e. according to the travel path. In general, a zero-crossing in the detected waveform occurs between a ground wave and a first sky wave, another one occurs between the first sky wave and a second sky wave, etc., wherein via the identification of the generation of a zero-crossing it can be identified whether it is a zero-crossing between a ground wave and a first sky wave and so on.

At the end of step S2, inter alia, the distance travelled, the incident angle and time, the amplitude and the polarity of the received signal, as a part of the whole emitted radiation are obtained in a first approximation at each remote station individually.

In a third step S3, the resulting data of the pre-processing is transferred from the remote stations to a data processing device via a data network, wherein the data network can be wireless, wired or a combination of both.

In a fourth step S4, the transmitted data from the plurality of the remote stations is gathered and ordered by arrival time at the remote stations.

In a fifth step S5, signal in close temporal proximity are grouped and an approximation of the lightning stroke location and time is calculated based on the corresponding results like incident angles and travelled distance.

In a sixth step S6, all signal data which sufficiently accurately match the estimated location and time of the lightning stroke are combined and the calculated location and time is iteratively refined using a least squares optimization algorithm. The optimizing iteration is conducted until a certain convergence level is reached. Hence, the optimization calculation returns at least the following values:
- latitude, longitude and height of the lightning stroke,
- incident time of the lightning stroke,
- amplitude of the lightning stroke,
- polarity of the lightning stroke, and
- estimation of the uncertainty of the resulting location.

Generally speaking, the general principle of the method 10 comprising step S1 to S6 is as follows:
A lightning stroke generates an electromagnetic pulse which is transmitted as an electromagnetic wave in the very long frequency (VLF) band (1 to 30 kHz). These electromagnetic waves can be detected and recorded by a (remote) station having an antenna (step S1). A GPS-based clock serves as precise time reference (precision of up to 100 ns) at the remote station and assigns a time point or time series to each signal received.

The signal emitted by a lightning stroke falls into the class of VLF signals. These signals are transmitted via two different modes: ground wave or sky waves.

The travel path of the ground wave is parallel to the earth's surface. Its travel time between an emitter and a receiver is therefore only dependent on the distance between the emitter and receiver.

Sky waves, on the other hand, are reflected by an atmospheric layer called ionosphere and travel by means of `hops' (reflections) between the earth's surface and the ionosphere. Depending on the number n of `hops', the sky waves are called first sky wave, second sky wave, etc. for n = 1,2, .... The travel path of a sky wave depends on its order n and the height of the ionosphere. The ionospheric reflection height changes with the time of day.

The importance of the different modes of wave propagation for the signal strength varies with increasing distance: groundwaves are most important for distances up to about 1000 km, beyond that the sky wave propagation becomes more significant.

If the signal recorded by a remote station is stronger than the usual background noise, it is assumed that it was originally generated by a lightning stroke. In this case (step S2), the signal is pre-processed by means of a big data algorithm (neural network) which has been trained using reference signals of lightning strokes with a known location and time.

Based on the shape or waveform of the electromagnetic wave the algorithm will return estimations for at least one of the following quantities:
- traveled distance of the signal,
- incident angle of the signal,
- incident times of the ground wave, first sky wave, second sky wave etc.,
- percentage of the travel path traveled at day- or nighttime, respectively, and
- amplitude and polarity of the lightning stroke.

Further on, the pre-processed signal data generated on the various remote stations are gathered on the data processing device or central processing unit and ordered by the arrival time of the respective electromagnetic waves (step S4). Signals in close temporal proximity are grouped and an approximation for the stroke location is calculated based on the approximate arrival time of the signal, the incident angle, and the estimated traveled distance (step S5).

All signals which are compatible with this estimated stroke location and time are then combined and the estimation for location and time is refined iteratively using a least squares optimization algorithm (step S6). Here, the distance of the sensor to the stroke location is taken into account to choose the appropriate signal mode (ground wave, first sky wave, etc.) that is used to determine the exact arrival time of the signal. The arrival time is a non-trivial function of the signal mode and the travel path. Certain parts of this equation can be derived from a-priori considerations while others have to be calibrated using existing signals and knowledge of the corresponding strokes.

After the optimization has converged, the data processing device or central processing unit will return a lightning stroke resolution which contains at least one of the following data:
- latitude, longitude and height of the stroke,
- time of the stroke, and
- amplitude and polarity of the stroke.

Preferably, an estimation of the uncertainty of the location is also indicated.

As mentioned above, in **Fig. 2****,** an embodiment of a system 100 for three-dimensional measuring of lightning strokes according to the present invention is shown, which is configured to execute the method 10 according to **Fig. 1****.**

The system 100 comprises at least a first and a second remote station 110, 120, a data network 130, and a data processing device 140.

In the embodiment, the data network 130 connects the two remote stations 110, 120 to the data processing device 140 via network connections 132, 134, which can be wired or wireless.

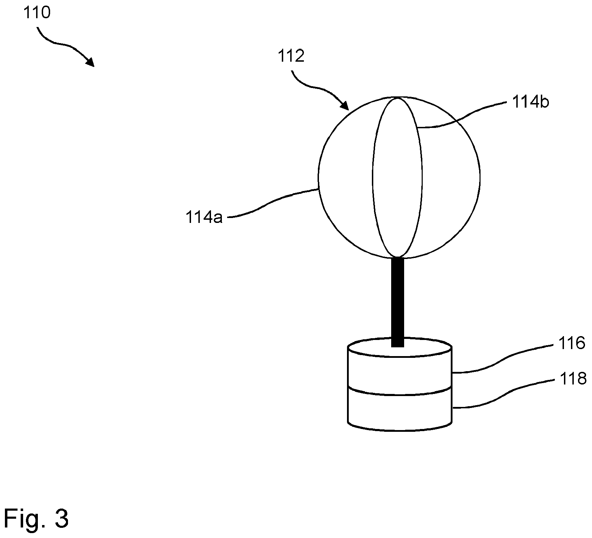

The remote stations 110, 120 are described in further detailed below in connection with **Fig. 3****.**

In **Fig. 2****,** as an example, a lightning stroke Lcc between two thunderclouds C is shown. The lightning stroke Lee emits electromagnetic waves, two of which are indicated in **Fig. 2** as a first wave or signal 210 and a second signal 220.

The propagation of the electromagnetic waves or signals 210, 220 emitted by the lightning stroke L_{CC} is only shown in a very simplified way in **Fig. 2****.**

The first signal 210, starting from the lightning stroke Lee, is first reflected at the ionosphere IS at a first reflection point or hop 212, wherein the height of the ionosphere changes with the day time.

In its further propagation, the first signal 210 is reflected once again at a second hop 214 on the earth's surface ES before reaching the two remote stations 110, 120.

The second signal 220 is only reflected once at a hop 222 on the earth's surface ES before reaching the right remote stations 120.

Both signals 210, 220 thus propagate differently, i.e. show different propagation modes which have to be considered during the signal analysis when determining the location of the lightning stroke Lee.

The signals 210, 220 are detected and received, according to the first step S1 of the method according to the present invention, at the remote stations 110, 120.

Referring in particular to the right remote station 120, both signal 210, 220 are received which results, dependent on their time of arrival, in a superposition of both signals 210, 220 at the receiving remote station 120. Consequently, the pre-processing at the remote stations 110, 120 comprises first a step of identifying characteristic features, followed by assigning these features to one of the two signals 210, 220.

It should also be understood that the signals 210, 220 in **Fig. 2** are shown as arriving at the right station at the same time for display purposes, in practice there is more likely to be a time offset due to the different travel paths, so it is of particular importance that each arriving signal is assigned a precise time of arrival.

At the remote stations 110, 120, the received signals are pre-processed according to the step S2 of the method. Hence, specific features and metadata are extracted from the signal shape or waveform as well as a labelling of the extracted features according to their propagation mode is performed, provided that a predetermined threshold level is exceeded. The labelling, which comprises a signal analysis, is performed by means of a machine learning method such as a neural network, which is trained with known reference lightning stroke values.

Thus, at the end of step S2 at the remote stations 110, 120, inter alia, the distance travelled, the incident angle and time, the amplitude and the polarity of the received signal, as a part of the whole emitted lightning radiation are obtained in a first approximation at each remote station 110, 120 individually.

The pre-processed signal data is then being transferred from the remote stations 110, 120 via the data network 130 to the data processing device 140, corresponding to the method step S3, wherein the remote station 110 is connected or linked to the data processing device 140 by the network connection 132 and the remote station 120 via the network connection 134, respectively.

At the data processing device 140, the method steps S4 to S6 are performed which means that the transmitted signal data from the remote stations 110, 120 is gathered and subsequently ordered by arrival time at the respective stations 110, 120 (step S4). Following this, signal data in close temporal proximity is grouped and an approximation of the lightning stroke location and time is calculated based on the corresponding results like incident angles and travelled distance (step S5). Finally, in the method step S6, signal data which sufficiently matches the estimated location and time of the lightning stroke is combined and the calculated location and time is iteratively refined using a least squares optimization algorithm. Thus, the optimization calculation returns at least the following values: latitude, longitude and height of the lightning stroke, incident time of the lightning stroke Lee, amplitude of the lightning stroke Lee, polarity of the lightning stroke Lee, and preferably an estimation of the uncertainty of the resulting location.

**Fig. 3** shows in more detail one of the two remote stations 110, 120 of **Fig. 2****,** wherein preferably all remote stations used in the system 100 are of the same kind.

The embodiment of the remote station 110 according to the present invention, as shown in **Fig. 3****,** comprises an antenna 112 having two perpendicularly aligned conductive loops 114a, 114b, a GPS clock 116 serving as a precise time reference, and a processor 118.

The two perpendicularly aligned conductive loops 114a, 114b measure the magnetic component of electromagnetic waves emitted by a lightning stroke.

Further, the remote station 110 can comprise an ADC to convert the received analogue signal 210 into a digitally processable signal, a communication interface by which the network connection 132 is established, a memory unit, and a power supply or connection to ensure a continuous operation of the respective remote station 110. It is also conceivable that the processor 118 and the memory unit form a combined device, i.e. the memory unit is part of the processor.

The processor 118 is connected to the remote station 118 and records the time series of the magnetic field intensity measured, detected or received by the two perpendicularly aligned conductive loops 114a, 114b. Whenever the recorded magnetic field exceeds a specified threshold level, the pre-processing step S2 is invoked, as explained above in connection with Fig. 1, and the resulting data or information is stored and transmitted to the data processing device 140 (central processing unit) via the data network 130 (step S3).

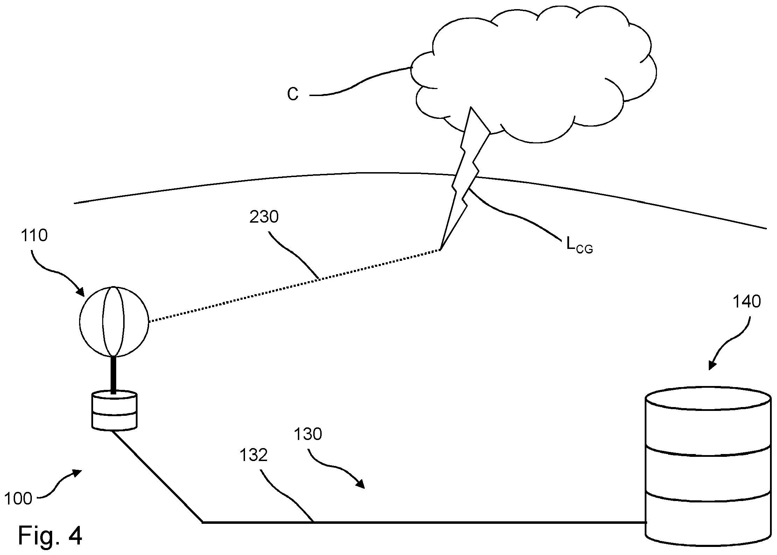

Referring to **Fig. 4****,** a cloud-to-ground lightning stroke L_{CG} is illustrated. For reasons of simplification, only one remote station 110 is shown.

However, it should be understood that the system 100 comprises a plurality of remote stations, wherein the term "remote" should indicate that the detecting stations are spatially separated from each. The stations are preferably arranged in such a way that they cover a sufficiently large section of the earth's surface ES and the corresponding atmosphere above to detect and record weather phenomena, especially lightning strokes.

The cloud-to-ground lightning stroke L_{CG} in **Fig. 4** emits a ground wave or signal 230 which is not reflected by either the ionosphere IS or the earth's surface ES, i.e. Hence, the travel time of the part of the radiation of the lightning stroke L_{CG} emitted as ground wave is only dependent on the distance between lightning stroke L_{CG} and remote station 110.

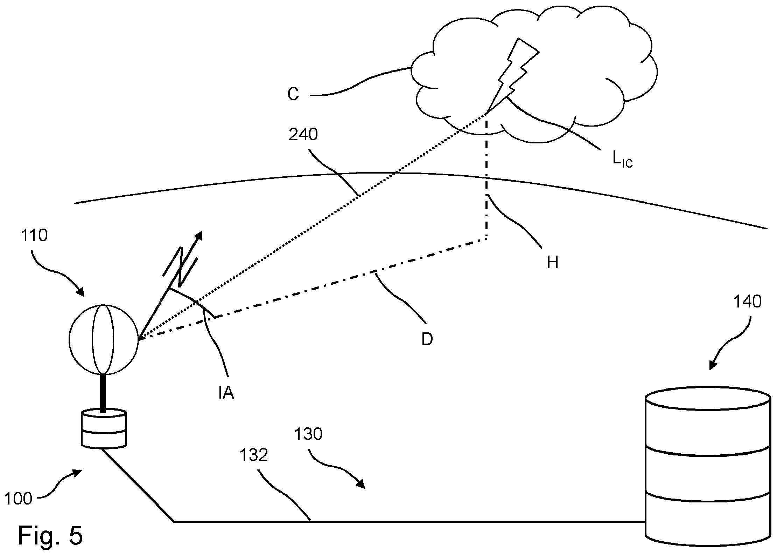

**Fig. 5** finally illustrates an intracloud lightning stroke Lie whose one part of the radiation directly travels as an electromagnetic wave 240 to the remote station 110, i.e. without any reflections, and is received there at the antenna.

It should nevertheless be understood that the lightning stroke Lie does not emit a single unidirectional electromagnetic wave, but only individual parts of the whole emitted electromagnetic radiation are highlighted and facilitated here to explain the method 10 according to the present invention.

What can be derived from the detected electromagnetic signal 240, as presented in **Fig. 5****,** is inter alia the incident time, the height H and distance D from the remote station 110 to the lightning stroke Lie as well as the incident angle IA which refers to a compass direction. Thus, the lightning stroke Lie can be determined in space and time based on the location of the remote station 110. In this respect, it is obvious that the precision of the location and time increases with the number of remote stations used.

### Reference signs:

- 10: method for three-dimensional measuring of a lightning stroke
- 100: system for three-dimensional measuring of a lightning stroke
- 110: first remote station
- 112: antenna
- 114a, 114b: conductive loops
- 116: GPS clock
- 118: processor
- 120: second remote station
- 130: data network
- 132, 134: network connections
- 140: data processing device
- 210: first electromagnetic wave
- 212: first hop of first electromagnetic wave
- 214: second hop of first electromagnetic wave
- 220: second electromagnetic wave
- 222: first hop of second electromagnetic wave
- 230: ground (electromagnetic) wave
- 240: direct electromagnetic wave
- C: cloud
- D: distance
- ES: earth's surface
- H: height
- IA: incident angle
- is: ionosphere
- L: lightning stroke
- S1: detecting and recording
- S2: converting
- S3: pre-processing
- S4: transferring
- S5: gathering and ordering
- S6: grouping and estimating
- S7: iteratively optimizing
- S8: returning location and time results

## Claims

1. A method (10) for three-dimensional measuring of lightning strokes (L) comprising the steps of:
- recording, at a plurality of remote stations (110, 120), electromagnetic waves generated by a lightning stroke (L);
- pre-processing the recorded electromagnetic wave data;
- transferring the pre-processed electromagnetic wave data of the plurality of remote stations (110, 120) to at least one data processing device (140) via at least one data network (130);
- processing the transferred electromagnetic wave data of the plurality of remote stations (110, 120) at the at least one data processing device (140); and
- determining a resolution of the lightning stroke (L) based on the processed electromagnetic wave data.

2. The method (10) for three-dimensional measuring of lightning strokes (L) according to claim 1,
**characterized in that**
the resolution of the lightning stroke (L) comprises at least a time and a location of the lightning stroke (L).

3. The method (10) for three-dimensional measuring of lightning strokes (L) according to claim 1 or 2,
**characterized in that**
the step of recording comprises converting the detected electromagnetic waves generated by a lightning stroke (L) into electromagnetic wave data.

4. The method (10) for three-dimensional measuring of lightning strokes (L) according to one of the preceding claims,
**characterized in that**
the step of pre-processing comprises applying at least one machine learning method.

5. The method (10) for three-dimensional measuring of lightning strokes (L) according to one of the preceding claims,
**characterized in that**
the step of pre-processing comprises storing the pre-processed electromagnetic wave data.

6. The method (10) for three-dimensional measuring of lightning strokes (L) according to one of the preceding claims,
**characterized in that**
the step of pre-processing comprises determining from a waveform of the electromagnetic wave data at least one feature of the group of zero-crossings, halfway points between neighbouring peaks, and first threshold exceeding points.

7. The method (10) for three-dimensional measuring of lightning strokes (L) according to claim 6,
**characterized in that**
the step of pre-processing comprises determining from the waveform metadata of the group of estimated propagation distance, polarity, and incident angle of the electromagnetic wave.

8. The method (10) for three-dimensional measuring of lightning strokes (L) according to claim 6 or claim 7,
**characterized in that**
the step of pre-processing comprises labelling the features according to a propagation mode.

9. The method (10) for three-dimensional measuring of lightning strokes (L) according to one of the preceding claims,
**characterized in that**
the step of processing comprises ordering the transferred electromagnetic wave data of the remote stations (110, 120) by the time of arrival.

10. The method (10) for three-dimensional measuring of lightning strokes (L) according to claim 9,
**characterized in that**
the step of processing comprises grouping the ordered electromagnetic wave data according to a temporal proximity.

11. The method (10) for three-dimensional measuring of lightning strokes (L) according to one of the preceding claims,
**characterized in that**
the step of processing comprises calculating an approximation of the resolution.

12. The method (10) for three-dimensional measuring of lightning strokes (L) according to one of the preceding claims,
**characterized in that**
the step of determining comprises applying an optimization algorithm to the processed electromagnetic wave data.

13. The method (10) for three-dimensional measuring of lightning strokes (L) according to claim 12,
**characterized in that**
the optimization algorithm is a least squares optimization algorithm.

14. A system (100) for three-dimensional measuring of lightning strokes (L), comprising:
- a plurality of remote stations (110, 120),
- at least one data network (130), and
- at least one data processing device (140),
wherein the remote stations (110, 120) are connected to the at least one data processing device (140) via the at least one data network (130),
wherein each remote station (110, 120) comprises at least one antenna (112) configured to detect electromagnetic waves (210, 220, 230, 240), in particular electromagnetic waves of a very low frequency (VLF) band generated by a lightning stroke (L), at least one processor (118) configured to process the detected electromagnetic waves (210, 220, 230, 240) by at least one machine learning method, and a GPS clock (116) configured to assign an individual time stamp to each detected electromagnetic wave (210, 220, 230, 240), and
wherein the at least one data processing device (140) is configured to determine at least a location and a time of the lightning stroke (L) by an optimization algorithm.

15. The system (100) for three-dimensional measuring of lightning strokes (L) according to claim 14,
**characterized in that**
the at least one antenna (112) comprises two at least substantially perpendicularly aligned conductive loops (114a, 114b) configured to receive the magnetic component of the detected electromagnetic wave (210, 220, 230, 240).

16. The system (100) for three-dimensional measuring of lightning strokes (L) according to claim 14 or 15,
**characterized in that**
the at least one processor (118) is configured to record the magnetic component of the electromagnetic wave (210, 220, 230, 240) over time.

17. The system (100) for three-dimensional measuring of lightning strokes (L) according to one of claims 14 to 16,
**characterized in that**
the data network (130) is established wired and/or wireless.
